(19) Europäisches Patentamt
European Patent Office
Office européen des brevets

(11) **EP 3 258 489 B1**

(12) **EUROPEAN PATENT SPECIFICATION**

(45) Date of publication and mention of the grant of the patent:
**11.05.2022   Bulletin 2022/19**

(21) Application number: **16748904.6**

(22) Date of filing: **04.02.2016**

(51) International Patent Classification (IPC):
*H01L 23/36* (2006.01)    *H01L 23/42* (2006.01)
*H01L 23/373* (2006.01)    *H05K 7/20* (2006.01)
*B29C 48/08* (2019.01)

(52) Cooperative Patent Classification (CPC):
**H01L 23/373; B29C 48/08; H01L 23/3737;
H01L 23/42; H05K 7/20**

(86) International application number:
**PCT/JP2016/000583**

(87) International publication number:
**WO 2016/129257 (18.08.2016 Gazette 2016/33)**

(54) **HEAT TRANSFER SHEET AND METHOD FOR PRODUCING SAME**

WÄRMEÜBERTRAGUNGSFOLIE UND VERFAHREN ZUR HERSTELLUNG DAVON

FEUILLE DE TRANSFERT DE CHALEUR ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.02.2015   JP 2015024771**

(43) Date of publication of application:
**20.12.2017   Bulletin 2017/51**

(73) Proprietor: **Zeon Corporation**
**Tokyo 100-8246 (JP)**

(72) Inventors:
 • **KUMAMOTO, Takurou**
**Tokyo 100-8246 (JP)**
 • **ARAKAWA, Kohei**
**Tokyo 100-8246 (JP)**

(74) Representative: **Maiwald Patent- und
Rechtsanwaltsgesellschaft mbH
Elisenhof
Elisenstraße 3
80335 München (DE)**

(56) References cited:
**EP-A1- 1 471 114      WO-A1-2008/062844
WO-A1-2010/073880      JP-A- H11 302 545
JP-A- 2001 250 894      JP-A- 2005 150 362
JP-A- 2011 025 676      JP-A- 2012 171 986
JP-A- 2013 256 578      US-A1- 2014 175 321**

**Description**

TECHNICAL FIELD

The present disclosure relates to heat conductive sheets and methods of manufacturing the same.

BACKGROUND

In recent years, electronic parts such as plasma display panels (PDPs) and integrated circuit (IC) chips generate more heat along with their increasing performance. This has led to the necessity of taking measures to prevent function failure due to temperature rises in the electronic parts of electronic devices.

General measures to prevent function failure due to temperature rise involve attaching a heat radiator such as a metallic heat sink, radiation plate or radiation fin to a heat source such as an electronic part to facilitate heat dissipation. When a heat radiator is used, the heat radiator and the heat source are closely attached to each other via a sheet member having high heat conductivity (heat conductive sheet) in order to effectively transfer heat from the heat source to the heat radiator. Hence, heat conductive sheets sandwiched between a heat source and a heat radiator during use are required to have high flexibility and superior strength, as well as high heat conductivity.

To that end, for example, PTL 1 discloses as a heat conductive sheet with superior heat conductivity, flexibility and strength, a heat conductive sheet containing graphite particles oriented in thickness direction, wherein the heat conductive sheet is prepared using a composition containing: a reaction product between a specific carboxylic group-containing acrylate copolymer resin and a specific epoxy curing agent; and graphite particles of flake, elliptical sphere or rod shape having its 6-membered ring plane in the crystal oriented in the plane direction of the flake, in the major axis direction of the elliptical sphere or in the major axis of the rod. PTL2 refers to a heat radiating resin composition comprising a thermoplastic resin and carbon fiber structures having an outer diameter of 15-100 nm and graphite particles. PTL 3 refers to a thermoplastic resin composition comprising a thermoplastic resin and carbon nanotubes having a diameter of 0,5-120nm.

CITATION LIST

Patent Literature

    PTL 1: JP2010-132856A
    PTL 2: WO2008/062844
    PTL 3: EP1471114 A1

SUMMARY

(Technical Problem)

However, the improved strength of the heat conductive sheet disclosed in PTL 1 is attained by the reaction between the specific carboxylic group-containing acrylate copolymer resin and the specific epoxy curing agent to crosslink the carboxylic group-containing acrylate copolymer resin. Hence, high levels of flexibility and strength cannot be attained at the same.

It would therefore be helpful to provide a heat conductive sheet that has sufficiently high levels of heat conductivity, flexibility and strength at the same time.

It would also be helpful to provide a method of manufacturing a heat conductive sheet, which method may allow for effective manufacture of a heat conductive sheet that has sufficiently high levels of heat conductivity, flexibility and strength at the same time.

(Solution to Problem)

The inventors made extensive studies to achieve the foregoing object. As a result, the inventors discovered that a heat conductive sheet prepared using a composition containing a resin, a particulate carbon material and a fibrous carbon material is superior in all of heat conductivity, flexibility and strength. The inventors completed the present disclosure based on this discovery.

Specifically, the present disclosure is aimed at advantageously solving the foregoing problem, and the disclosed heat conductive sheet has a heat conductivity in thickness direction of 20 W/m·k or more, an Asker C hardness of 70 or less, and a tensile strength of 1.5 MPa or more. In such a heat conductive sheet, sufficiently high levels of heat conductivity, flexibility and strength are established at the same time.

The present disclosure is aimed at advantageously solving the foregoing problem, and the disclosed heat conductive sheet has a resin, a particulate carbon material, and a fibrous carbon material. Blending both of particulate and fibrous carbon materials results in a heat conductive sheet that has sufficiently high levels of heat conductivity, flexibility and strength at the same time. Blending of a fibrous carbon material can also prevent fall of a particulate carbon material.

Specifically, the disclosed heat conductive sheet can have a heat conductivity in thickness direction of, for example, 20 W/m·k or more. The disclosed heat conductive sheet can also have an Asker C hardness of, for example, 70 or less. Further, the disclosed heat conductive sheet can have a tensile strength of, for example, 1.5 MPa or more.

The disclosed heat conductive sheet can be obtained by slicing a laminate at an angle of 45° or less relative to the lamination direction, the laminate being obtained either by laminating on top of each other pre-heat conductive sheets, each obtained by shaping a composition containing the resin, the particulate carbon material and the fibrous carbon material into a sheet by pressure application, or by folding or rolling the pre-heat conductive sheet.

The disclosed heat conductive sheet preferably contains the fibrous carbon material at an amount of 0.05% by mass to 5% by mass. By setting the fibrous carbon material content to be 0.05% by mass to 5% by mass, it is possible to attain higher levels of heat conductivity, flexibility and strength at the same time while sufficiently preventing fall of the particulate carbon material.

The disclosed heat conductive sheet preferably contains the particulate carbon material at an amount of 30% by mass to 90% by mass. By setting the particulate carbon material content to be 30% by mass to 90% by mass, it is possible to attain higher levels of heat conductivity, flexibility and strength at the same time while sufficiently preventing fall of the particulate carbon material.

The disclosed heat conductive sheet preferably shows changes in heat conductivity of 20% or less between 25C° and 90C°. When heat conductivity changes between 25C° and 90C° are within 20% (i.e., from -20% to +20%), it is possible to allow the heat conductive sheet to have superior heat conductivity over a wide temperature range.

The disclosed heat conductive sheet preferably has a tear strength of 5.6 N/mm or more. Tear strength of 5.6 N/mm or more provides for sufficient levels of handleability and workability.

The present disclosure is aimed at advantageously solving the foregoing problem, and the disclosed method of manufacturing a heat conductive sheet includes the steps of: shaping a composition containing a resin, a particulate carbon material, and a fibrous carbon material into a sheet by pressure application to provide pre-heat conductive sheet(s); obtaining a laminate either by laminating the pre-heat conductive sheets on top of each other or by folding or rolling the pre-heat conductive sheet; and slicing the laminate at an angle of 45° or less relative to the lamination direction to provide a heat conductive sheet. When a laminate formed of pre-heat conductive sheet(s) obtained by shaping a composition containing a resin, a particulate carbon material and a fibrous carbon material into a sheet by pressure application is sliced at an angle of 45° or less relative to the lamination direction in this way, it is possible to easily manufacture a heat conductive sheet having sufficiently high levels of heat conductivity, flexibility and strength at the same time.

In the present disclosure, "heat conductivity" is calculated using the following Equation (I):

$$\text{Heat conductivity } \lambda \text{ (W/m·K)} = \alpha \times Cp \times \rho \ldots (I)$$

where $\alpha$ is thermal diffusivity (m$^2$/s), Cp is specific heat at constant pressure (J/g·K), and $\rho$ is specific gravity (g/m$^3$) of the heat conductive sheet. "Thermal diffusivity" can be measured using a thermal analyzer, "specific heat at constant pressure" can be measured using a differential scanning calorimeter, and "specific gravity" can be measured using an automatic specific gravity meter.

In the present disclosure, "Asker C hardness" can be measured at a temperature of 23°C using a hardness meter according to the Asker C method of the Society of Rubber Industry, Japan Standard (SRIS).

In the present disclosure, "tensile strength" can be measured with a tensile tester at a temperature of 25°C and a tensile rate of 500 mm/min.

In the present disclosure, "tear strength" can be measured with a tensile tester at a temperature of 25°C and a tensile rate of 200 mm/min.

(Advantageous Effect)

According to the present disclosure, it is possible to provide a heat conductive sheet that has sufficiently high levels of heat conductivity, flexibility and strength at the same time, and a method of effectively manufacturing the same.

DETAILED DESCRIPTION

An embodiment of the present disclosure will now be described in detail.

For use, the disclosed heat conductive sheet can be sandwiched for example between a heat source and a heat radiator when attaching the heat radiator to the heat source. Specifically, the disclosed heat conductive sheet can constitute a heat radiation device together with a heat radiator such as a heat sink, radiator plate or radiator fin. The disclosed heat conductive sheet can be manufactured for example by the disclosed method of manufacturing a heat conductive sheet.

(Heat Conductive Sheet)

The disclosed heat conductive sheet contains a resin, a particulate carbon material and a fibrous carbon material, and optionally contains additives. Because the disclosed heat conductive sheet contains both of particulate and fibrous carbon materials, it is possible to attain sufficiently high levels of heat conductivity, flexibility and strength at the same time. Because the disclosed heat conductive sheet contains the fibrous carbon material, it is possible to prevent fall of the particulate carbon material. An uncertain but possible reason that fall of the particulate carbon material can be prevented by blending the fibrous carbon material is that the fibrous carbon material forms a three-dimensional network structure which prevents detachment of the particulate carbon material while increasing heat conductivity and strength.

<Resin>

Any resin can be used and any of the resins known in the art which may be used for forming a heat conductive sheet can be used. Specific examples of usable resins are thermoplastic or thermosetting resins. In the present disclosure, "resin" encompasses rubbers and elastomers. Thermoplastic resins and thermosetting resins may be used in combination.

[Thermoplastic Resins]

Examples of thermoplastic resins include acrylic resins such as poly(2-ethylhexyl acrylate), copolymers of acrylic acid and 2-ethylhexyl acrylate, polymethacrylic acids or esters thereof, and polyacrylic acids or esters thereof; silicone resins; fluororesins such as polyvinylidene fluoride and polytetrafluoroethylene; polyethylenes; polypropylenes; ethylene-propylene copolymers; polymethylpentenes; polyvinyl chlorides; polyvinylidene chlorides; polyvinyl acetates; ethylene-vinyl acetate copolymers; polyvinyl alcohols; polyacetals; polyethylene terephthalates; polybutylene terephthalates; polyethylene naphthalates; polystyrenes; polyacrylonitriles; styrene-acrylonitrile copolymers; acrylonitrile-butadiene-styrene copolymers (ABS resins); styrene-butadiene block copolymers or hydrogenated products thereof; styrene-isoprene block copolymers or hydrogenated products thereof; polyphenylene ethers; modified polyphenylene ethers; aliphatic polyamides; aromatic polyamides; polyamideimides; polycarbonates; polyphenylene sulfides; polysulfones; polyether sulfones; polyether nitriles; polyether ketones; polyketones; polyurethanes; liquid crystal polymers; and ionomers. These thermoplastic resins may be used alone or in combination.

[Thermosetting Resins]

Examples of thermosetting resins include natural rubbers; butadiene rubbers; isoprene rubbers; nitrile rubbers; hydrogenated nitrile rubbers; chloroprene rubbers; ethylene propylene rubbers; chlorinated polyethylenes; chlorosulfonated polyethylenes; butyl rubbers; halogenated butyl rubbers; polyisobutylene rubbers; epoxy resins; polyimide resins; bismaleimide resins; benzocyclobutene resins; phenol resins; unsaturated polyesters; diallyl phthalate resins; polyimide silicone resins; polyurethanes; thermosetting polyphenylene ethers; and thermosetting modified polyphenylene ethers. These thermosetting resins may be used alone or in combination.

Of these resins mentioned above, preferred for the heat conductive sheet are thermoplastic resins. The use of thermoplastic resins enhances flexibility of the heat conductive sheet so that the heat source and heat radiator can be well closely attached to each other via the heat conductive sheet.

<Particulate Carbon Material>

Any particulate carbon material can be used. Examples of usable particulate carbon materials include graphite such as artificial graphite, flake graphite, flaked graphite, natural graphite, acid-treated graphite, expandable graphite, and expanded graphite; and carbon black. These particulate carbon materials may be used alone or in combination.

Of these particulate carbon materials, preferred is expanded graphite for its capability of enhancing heat conductivity of the heat conductive sheet.

[Expanded Graphite]

Expanded graphite which may be suitably used as the particulate carbon material can be obtained for example by thermal expansion of expandable graphite which has been obtained by chemical treatment of graphite such as flake graphite with sulfuric acid or the like, followed by micronization. Examples of expandable graphite include EC1500, EC1000, EC500, EC300, EC100, and EC50 (all trade names) available from Ito Graphite Co., Ltd.

[Properties of Particulate Carbon Material]

The particulate carbon material contained in the disclosed heat conductive sheet preferably has an average particle diameter of 0.1 $\mu$m or more, more preferably 1 $\mu$m or more, and preferably 500 $\mu$m or less, more preferably 100 $\mu$m or less. When the particulate carbon material has an average particle diameter that falls within this range, it is possible to enhance heat conductivity of the heat conductive sheet.
The particulate carbon material contained in the disclosed heat conductive sheet preferably has an aspect ratio (major axis/minor axis) of 1 to 10, more preferably 1 to 5.
In the present disclosure, "average particle diameter" can be found by measuring maximum diameters (major diameters) for randomly-selected 50 particulate carbon materials observed in a vertical (thickness direction) cross-sectional scanning electron micrograph (SEM) of the heat conductive sheet, and calculating the number-average of the measured major diameters. In the present disclosure, "aspect ratio" can be found by measuring maximum diameters (major diameters) and diameters in a direction perpendicular to the maximum diameter (minor diameters) for randomly-selected 50 particulate carbon materials observed in a vertical (thickness direction) cross-sectional scanning electron micrograph (SEM) of the heat conductive sheet, and calculating the average of ratios of the major diameter to the minor diameter (major diameter/minor diameter).

[Particulate Carbon Material Content]

The heat conductive sheet preferably contains the particulate carbon material at an amount of 30% by mass or more, more preferably 40% by mass or more, even more preferably 50% by mass or more, and preferably 90% by mass or less, more preferably 80% by mass or less, even more preferably 75% by mass or less. When the heat conductive sheet contains the particulate carbon material at an amount of 30% by mass to 90% by mass, it is possible to sufficiently increase heat conductivity, flexibility and strength of the heat conductive sheet in a well-balanced manner. When the heat conductive sheet contains the particulate carbon material at an amount of 90% or less, it is possible to sufficiently prevent fall of the particulate carbon material.

<Fibrous Carbon Material>

Any fibrous carbon material can be used. Examples of usable fibrous carbon materials include carbon nanotubes, vapor grown carbon fibers, carbon fibers obtained by carbonization of organic fibers, and chopped products thereof. These fibrous carbon materials may be used alone or in combination.
Of these fibrous carbon materials, preferred are fibrous carbon nanostructures such as carbon nanotubes, with fibrous carbon nanostructures including carbon nanotubes being more preferred. The use of fibrous carbon nanostructures such as carbon nanotubes allows for further increases in heat conductivity, tensile strength and tear strength of the heat conductive sheet.

[Fibrous Carbon Nanostructures including Carbon Nanotubes]

The fibrous carbon nanostructures including carbon nanotubes, which may be suitably used as the fibrous carbon material, may be composed solely of carbon nanotubes (hereinafter occasionally referred to as "CNTs") or may be a mixture of CNTs and fibrous carbon nanostructures other than CNTs.
Any type of CNTs may be used in the fibrous carbon nanostructures, such as, for example, single-walled carbon nanotubes and/or multi-walled carbon nanotubes, with single- to up to 5-walled carbon nanotubes being preferred, and single-walled carbon nanotubes being more preferred. The use of single-walled carbon nanotubes allows for further increases in heat conductivity and strength in the heat conductive sheet as compared to those containing multi-walled carbon nanotubes.
The fibrous carbon nanostructures including carbon nanotubes are preferably those having a ratio of a standard

deviation ($\sigma$) of diameters multiplied by 3 (3$\sigma$) to average diameter (Av) (3$\sigma$/Av) of greater than 0.20 to less than 0.60, more preferably those having 3$\sigma$/Av of greater than 0.25, even more preferably those having 3$\sigma$/Av of greater than 0.50. The use of fibrous carbon nanostructures including carbon nanotubes having 3$\sigma$/Av of greater than 0.20 to less than 0.60 allows for sufficient increases in heat conductivity and strength of the heat conductive sheet even when only small amounts of carbon nanostructures have been blended, limiting rises in hardness (i.e., reductions in flexibility) of the heat conductive sheet due to blending of the fibrous carbon nanostructures including CNTs so that a heat conductive sheet can be obtained that has sufficiently high levels of heat conductivity, flexibility and strength at the same time.

"Average diameter (Av) of fibrous carbon nanostructures" and "standard deviation ($\sigma$) (where $\sigma$ is sample standard deviation) of diameters of fibrous carbon nanostructures" can each be obtained by measuring the diameters (outer diameters) of 100 fibrous carbon nanostructures randomly-selected by transmission electron microscopy. The average diameter (Av) and standard deviation ($\sigma$) of the fibrous carbon nanostructures including carbon nanotubes may be adjusted either by changing the production method and/or the production conditions of the fibrous carbon nanostructures including carbon nanotubes or by combining different types of fibrous carbon nanostructures including CNTs, prepared by different production methods.

The fibrous carbon nanostructures including CNTs that are used typically take a normal distribution when a plot is made of diameter measured as described on the horizontal axis and the frequency on the vertical axis, and Gaussian approximation is made.

Furthermore, the fibrous carbon nanostructures including CNTs preferably exhibit a radial breathing mode (RBM) peak when evaluated by Raman spectroscopy. Note that no RBM appears in the Raman spectrum of fibrous carbon nanostructures composed solely of multi-walled carbon nanotubes having three or more walls.

In a Raman spectrum of the fibrous carbon nanostructures including CNTs, the ratio of G band peak intensity to D band peak intensity (G/D ratio) is preferably 1 to 20. G/D ratio of 1 to 20 allows for sufficient increases in heat conductivity and strength of the heat conductive sheet even when small amounts of fibrous carbon nanostructures have been blended, limiting rises in hardness (i.e., reductions in flexibility) of the heat conductive sheet due to blending of the fibrous carbon nanostructures so that a heat conductive sheet can be obtained that has sufficiently high levels of heat conductivity, flexibility and strength at the same time.

The fibrous carbon nanostructures including CNTs preferably have an average diameter (Av) of 0.5 nm or more, more preferably 1 nm or more, and preferably 15 nm or less, more preferably 10 nm or less. Average diameter (Av) of 0.5 nm or more can limit aggregation of fibrous carbon nanostructures to increase the dispersibility of the carbon nanostructures. Average diameter (Av) of 15 nm or less can sufficiently increase heat conductivity and strength of the heat conductive sheet.

The fibrous carbon nanostructures including CNTs preferably have an average length at the time of synthesis of 100 $\mu$m to 5,000 $\mu$m. Fibrous carbon nanostructures having a longer length at the time of synthesis are more susceptible to damage to CNTs by breaking, severing or the like during dispersing. Therefore, the average length of the nanostructures at the time of synthesis is preferably 5,000 $\mu$m or less.

The fibrous carbon nanostructures including CNTs preferably have a BET specific surface area of 600 m$^2$/g or more, more preferably 800 m$^2$/g or more, and preferably 2,500 m$^2$/g or less, more preferably 1,200 m$^2$/g or less. Moreover, when the CNTs of the fibrous carbon nanostructures are mainly open CNTs, it is preferable that the BET specific surface area is 1,300 m$^2$/g or more. BET specific surface area of 600 m$^2$/g or more can sufficiently increase heat conductivity and strength of the heat conductive sheet. BET specific surface area of 2,500 m$^2$/g or less can limit aggregation of the fibrous carbon nanostructures to increase the dispersibility of CNTs in the heat conductive sheet.

As used herein, "BET specific surface area" refers to a nitrogen adsorption specific surface area measured by the BET method.

In accordance with the super growth method described later, the fibrous carbon nanostructures including CNTs are obtained, on a substrate having thereon a catalyst layer for carbon nanotube growth, in the form of an aggregate wherein fibrous carbon nanostructures are aligned substantially perpendicularly to the substrate (aligned aggregate). The mass density of the fibrous carbon nanostructures in the form of such an aggregate is preferably 0.002 g/cm$^3$ to 0.2 g/cm$^3$. Mass density of 0.2 g/cm$^3$ or less allows the fibrous carbon nanostructures to be homogeneously dispersed within the heat conductive sheet because binding among the fibrous carbon nanostructures is weakened. Mass density of 0.002 g/cm$^3$ or more improves the unity of the fibrous carbon nanostructures thus preventing the fibrous carbon nanostructures from becoming unbound and making the fibrous carbon nanostructures easier to handle.

The fibrous carbon nanostructures including CNTs preferably include micropores. In particular, the fibrous carbon nanostructures preferably include pores that have a pore diameter of smaller than 2 nm. The abundance of these micropores as measured in terms of micropore volume determined by the method described below is preferably 0.40 mL/g or more, more preferably 0.43 mL/g or more, even more preferably 0.45 mL/g or more, with the upper limit being generally on the order of 0.65 mL/g. The presence of such micropores in the fibrous carbon nanostructures including CNTs limits aggregation of the fibrous carbon nanostructures so that a heat conductive sheet can be obtained that contains fibrous carbon nanostructures highly dispersed therein. Micropore volume can be adjusted for example by appropriate alteration of the production method and the production conditions of the fibrous carbon nanostructures including CNTs.

"Micropore volume (Vp)" can be calculated using Equation (II): Vp = (V/22414) × (M/p) by measuring a nitrogen adsorption and desorption isotherm of the fibrous carbon nanostructures including CNTs at liquid nitrogen temperature (77 K) with the amount of adsorbed nitrogen at a relative pressure of P/P0 = 0.19 defined as V, where P is a measured pressure at adsorption equilibrium, and P0 is a saturated vapor pressure of liquid nitrogen at time of measurement. In Equation (II), M is a molecular weight of 28.010 of the adsorbate (nitrogen), and $\rho$ is a density of 0.808 g/cm$^3$ of the adsorbate (nitrogen) at 77 K. Micropore volume can be measured for example using BELSORP®-mini (BELSORP is a registered trademark in Japan, other countries, or both) produced by Bel Japan Inc.

The fibrous carbon nanostructures including CNTs preferably exhibit a convex upward shape in a t-plot obtained from an adsorption isotherm. In particular, it is preferred that fibrous carbon nanostructures including CNTs have not undergone opening formation treatment as well as exhibit a convex upward shape in a t-plot. The "t-plot" can be obtained by converting relative pressure to average thickness t (nm) of an adsorbed layer of nitrogen gas in an adsorption isotherm of fibrous carbon nanostructures as measured by the nitrogen gas adsorption method. Specifically, an average adsorbed nitrogen gas layer thickness t corresponding to a given relative pressure is calculated from a known standard isotherm of average adsorbed nitrogen gas layer thickness t plotted against relative pressure P/P0 and the relative pressure is converted to the corresponding average adsorbed nitrogen gas layer thickness t to obtain a t-plot for the fibrous carbon nanostructures including CNTs (t-plot method of de Boer et al.).

The growth of an adsorbed layer of nitrogen gas for materials having pores at the surface is divided into the following processes (1) to (3). The gradient of the t-plot changes according to processes (1) to (3):

(1) a process in which a single molecular adsorption layer is formed over the entire surface by nitrogen molecules;
(2) a process in which a multi-molecular adsorption layer is formed in accompaniment to capillary condensation filling of pores; and
(3) a process in which a multi-molecular adsorption layer is formed on a surface that appears to be non-porous due to the pores being filled by nitrogen.

A t-plot having a convex upward shape shows a straight line crossing the origin in a region in which the average adsorbed nitrogen gas layer thickness t is small. However, as t increases, the plot deviates downward from the straight line. Fibrous carbon nanostructures that exhibit such a t-plot curve have a large internal specific surface area relative to total specific surface area of the fibrous carbon nanostructures, indicating the presence of a large number of openings formed in the carbon nanostructures that constitute the fibrous carbon nanostructures.

The t-plot for the fibrous carbon nanostructures including CNTs preferably has a bending point in a range of $0.2 \leq t \,(nm) \leq 1.5$, more preferably in a range of $0.45 \leq t \,(nm) \leq 1.5$, even more preferably in a range of $0.55 \leq t \,(nm) \leq 1.0$.

The "position of the bending point" is an intersection point of an approximate straight line A for process (1) and an approximate straight line B for process (3).

The fibrous carbon nanostructures including CNTs preferably have a ratio of internal specific surface area S2 to total specific surface area S1 (S2/S1) of 0.05 to 0.30, obtained from the t-plot.

The fibrous carbon nanostructures including CNTs can have any total specific surface area S1 and any internal specific surface area S2. However, S1 is preferably 600 m$^2$/g to 1,400 m$^2$/g, more preferably 800 m$^2$/g to 1,200 m$^2$/g. On the other hand, S2 is preferably 30 m$^2$/g to 540 m$^2$/g.

Total specific surface area S1 and internal specific surface area S2 of the fibrous carbon nanostructures including CNTs can be found from the t-plot. Specifically, first, total specific surface area S1 can be found from the gradient of an approximate straight line corresponding to process (1) and external specific surface area S3 can be found from the gradient of an approximate straight line corresponding to process (3). Internal specific surface area S2 can then be calculated by subtracting external specific surface area S3 from total specific surface area S1.

Measurement of adsorption isotherm, preparation of a t-plot, and calculation of total specific surface area S1 and internal specific surface area S2 based on t-plot analysis for fibrous carbon nanostructures including CNTs can be made using for example BELSORP®-mini (BELSORP is a registered trademark in Japan, other countries, or both), a commercially available measurement instrument available from Bel Japan Inc.

The fibrous carbon nanostructures including CNTs having the properties described above can be efficiently produced for example by the super growth method (see WO2006/011655), wherein during synthesis of CNTs through chemical vapor deposition (CVD) by supplying a feedstock compound and a carrier gas onto a substrate having thereon a catalyst layer for carbon nanotube production, the catalytic activity of the catalyst layer is dramatically improved by providing a trace amount of an oxidizing agent (catalyst activating material) in the system. Hereinafter, carbon nanotubes obtained by the super growth method may also be referred to as "SGCNTs."

The fibrous carbon nanostructures including CNTs produced by the super growth method may be composed solely of SGCNTs or may be composed of SGCNTs and non-cylindrical carbon nanostructures. Specifically, the fibrous carbon nanostructures including CNTs may include single- or multi-walled flattened cylindrical carbon nanostructures having over the entire length a "tape portion" where inner walls are in close proximity to each other or bonded together (hereinafter such carbon nanostructures are occasionally referred to as "graphene nanotapes (GNTs)").

GNT is presumed to be a substance having over the entire length a tape portion where inner walls are in close proximity to each other or bonded together since it has been synthesized, and having a network of 6-membered carbon rings in the form of flattened cylindrical shape. The GNT's flattened cylindrical structure and the presence of a tape portion where inner walls are in close proximity to each other or bonded together in the GNT can be confirmed for example as follows: GNT and fullerene (C60) are sealed into a quartz tube and subjected to heat treatment under reduced pressure (fullerene insertion treatment) to form a fullerene-inserted GNT, followed by observation under transmission electron microscopy (TEM) of the fullerene-inserted GNT to confirm the presence of part in the GNT where no fullerene is inserted (tape portion).

The phrase "having over the entire length a tape portion" used for GNTs refers to "having a tape portion over 60% or more, preferably 80% or more, more preferably 100% of the length of the longitudinal direction (entire length), either continuously or intermittently."

The shape of the GNT is preferably such that it has a tape portion at the central part in the width direction. More preferably, the shape of a cross-section of the GNT, perpendicular to the extending direction (axial direction), is such that the maximum dimension in a direction perpendicular to the longitudinal direction of the cross section is larger in the vicinity of opposite ends in the longitudinal direction of the cross section than in the vicinity of the central part in the longitudinal direction of the cross section. Most preferably, a cross-section of the GNT perpendicular to the extending direction (axial direction) has a dumbbell shape.

The term "vicinity of the central part in the longitudinal direction of a cross section" used for the shape of a cross section of GNT refers to a region within 30% of longitudinal dimension of the cross section from the line at the longitudinal center of the cross section (i.e., a line that passes through the longitudinal center of the cross section and is perpendicular to the longitudinal line in the cross section). The term "vicinity of opposite ends in the longitudinal direction of a cross section" refers to regions outside the "vicinity of the central part in the longitudinal direction of a cross section" in the longitudinal direction.

Carbon nanostructures including GNTs as non-cylindrical carbon nanostructures can be obtained by, when synthesizing CNTs by the super growth method using a substrate having thereon a catalyst layer (hereinafter occasionally referred to as a "catalyst substrate"), forming the catalyst substrate using a specific method. Specifically, carbon nanostructures including GNTs can be obtained by the super growth method using a catalyst substrate prepared as follows: coating liquid A containing an aluminum compound is applied on a substrate and dried to form an aluminum thin film (catalyst support layer) on the substrate, followed by application of coating liquid B containing an iron compound on the aluminum thin film and drying of the coating liquid B at a temperature of 50°C or below to form an iron thin film (catalyst layer) on the aluminum thin film.

[Properties of Fibrous Carbon Material]

The fibrous carbon material contained in the heat conductive sheet preferably has an average fiber diameter of 1 nm or more, preferably 3 nm or more, and preferably 2 $\mu$m or less, more preferably 1 $\mu$m or less. When the average fiber diameter of the fibrous carbon material falls within this range, it is possible to allow the heat conductive sheet to have sufficiently high levels of heat conductivity, flexibility and strength at the same time. The aspect ratio of the fibrous carbon material preferably exceeds 10.

In the present disclosure, "average fiber diameter" can be found by measuring fiber diameters for 50 randomly-selected fibrous carbon materials observed in a vertical (thickness direction) cross-sectional scanning electron micrograph (SEM) of the heat conductive sheet, and calculating the number-average of the measured fiber diameters. In the case of smaller fiber diameters, an average fiber diameter can be found using a similar method for a similar cross section observed by transmission electron microscopy (TEM).

[Fibrous Carbon Material Content]

The heat conductive sheet preferably contains the fibrous carbon material at an amount of 0.05% by mass or more, more preferably 0.2% by mass or more, and preferably 5% by mass or less, more preferably 3% by mass or less. When the heat conductive sheet contains the fibrous carbon material at an amount of 0.05% by mass or more, it is possible to sufficiently increase heat conductivity and strength of the heat conductive sheet, as well as to sufficiently prevent fall of the fibrous carbon material. When the heat conductive sheet contains the fibrous carbon material at an amount of 5% by mass or less, it is possible to limit rises in hardness (i.e., reductions in flexibility) of the heat conductive sheet due to blending of the fibrous carbon material so that a heat conductive sheet can be obtained that has sufficiently high levels of heat conductivity, flexibility and strength at the same time.

<Additives>

The heat conductive sheet can be optionally blended with additives known in the art that may be used for forming heat conductive sheets. Any additive may be blended into the heat conductive sheet. Examples of additives include plasticizers; flame retardants such as phosphorus red-based flame retardants and phosphate-based flame retardants; toughness improvers such as urethane acrylates; moisture absorbents such as calcium oxide and magnesium oxide; adhesion improvers such as silane coupling agents, titanium coupling agents, and acid anhydrides; wettability improvers such as nonionic surfactants and fluorine surfactants; and ion trapping agents such as inorganic ion exchangers.

<Properties of Heat Conductive Sheet>

The disclosed heat conductive sheet has any property but preferably has the following properties.

[Heat Conductivity]

The heat conductive sheet preferably has a heat conductivity in thickness direction at 25°C of 20 W/m·k or more, more preferably 30 W/m·k or more, even more preferably 40 W/m·k or more. Heat conductivity of 20 W/m·k or more allows the heat conductive sheet, when for example sandwiched between a heat source and a heat radiator, to effectively transfer heat from the heat source to the heat radiator.
The disclosed heat conductive sheet preferably shows changes in heat conductivity of 20% or less, more preferably 15% or less, between 25C° and 90C°. When heat conductivity changes are 20% or less, it is possible to allow the heat conductive sheet to have superior heat conductivity over a wide temperature range.

[Hardness]

The heat conductive sheet preferably has an Asker C hardness of 70 or less, more preferably 65 or less. Asker C hardness of 70 or less allows the heat conductive sheet, when for example sandwiched between a heat source and a heat radiator, to have superior flexibility allowing the heat source and the heat radiator to be well closely attached to each other.

[Strength]

The heat conductive sheet preferably has a tensile strength of 1.5 MPa or more, more preferably 2.0 MPa or more, even more preferably 2.2 MPa or more. Tensile strength of 1.5 MPa or more leads to easy handling and working while sufficiently limiting possible damage of the heat conductive sheet upon attachment or during use. In light of its relationship with hardness, tensile strength is preferably 10 MPa or less.
The heat conductive sheet preferably has a tear strength of 5.6 N/mm or more, more preferably 7.0 N/mm or more. Tear strength of 5.6 N/mm or more allows for easy handling and working. In particular, tear strength of 7.0 N/mm or more makes it possible to sufficiently prevent tearing of the heat conductive sheet upon attachment or detachment. In light of its relationship with hardness, tear strength is preferably 50 N/mm or less.

[Thickness]

The heat conductive sheet preferably has a thickness of 0.1 mm to 10 mm.

(Method of Manufacturing Heat Conductive Sheet)

The heat conductive sheet described above can be manufactured by any method, e.g., by the method including the steps of: forming a pre-heat conductive sheet using a composition containing a resin, a particulate carbon material and a fibrous carbon material (pre-heat conductive sheet forming step); forming a laminate using the resultant pre-heat conductive sheet(s) (laminate forming step); and slicing the laminate (slicing step).
Each step will be described in detail below.

<Pre-Heat Conductive Sheet Forming Step>

In the pre-heat conductive sheet forming step, a composition containing a resin, a particulate carbon material and a fibrous carbon material, and optionally further an additive, is shaped into a sheet by pressure application to provide a pre-heat conductive sheet.

[Composition]

The composition can be prepared by mixing a resin, a particulate carbon material and a fibrous carbon material, and optionally an additive. The resin, particulate carbon material, fibrous carbon material and additive can be those mentioned above which may be contained in the disclosed heat conductive sheet. It should be noted that when a cross-linked resin is used as the resin for the heat conductive sheet, a pre-conductive sheet may be formed using a composition containing a cross-linked resin, or may be formed using a composition containing a cross-linkable resin and a curing agent, after which the cross-linkable resin is cross-linked to introduce the cross-linked resin into the heat conductive sheet.

Mixing can be achieved by any means, e.g., using any of the mixing devices known in the art, such as a kneader, a roll or a mixer. Mixing may be effected in the presence of solvent such as ethyl acetate. Mixing time can for example range from 5 minutes to 60 minutes. Mixing temperature can for example range from 5°C to 150°C.

[Shaping of Composition]

The composition prepared in the manner described above can then be shaped into a sheet by pressure application, optionally after it has been defoamed and disintegrated. When solvent has been used during mixing, it is preferred to remove the solvent before shaping the composition into a sheet. For example, when defoaming is performed under vacuum, solvent can be removed at the same time as defoaming.

Any method can be used for shaping of the composition as long as pressure is applied. The composition can be shaped into a sheet by shaping methods known in the art, such as pressing, rolling or extruding. In particular, it is preferred that the composition is shaped into a sheet by rolling, more preferably by passing the composition between rolls with the composition sandwiched between protection films. Any protection film can be used, e.g., sandblasted polyethylene terephthalate films can be used. Roll temperature can range from 5°C to 150°C

[Pre-Heat Conductive Sheet]

In the pre-heat conductive sheet obtained by shaping the composition into a sheet by pressure application, particulate carbon materials and fibrous carbon materials are aligned mainly in the in-plane direction and this configuration is presumed to contribute to improved heat conductivity particularly in the in-plane direction.

The pre-heat conductive sheet can have any thickness, e.g., can have a thickness of 0.05 mm to 2 mm. From the perspective of enhancing heat conductivity of the heat conductive sheet, the thickness of the pre-heat conductive sheet is preferably greater than 20 times to 5,000 times the average particle diameter of the particulate carbon material.

<Laminate Forming Step>

In the laminate forming step, a laminate is obtained either by laminating on top of each other pre-heat conductive sheets obtained in the pre-heat conductive sheet forming step, or by folding or rolling the pre-heat conductive sheet. Formation of a laminate by folding of the pre-heat conductive sheet can be accomplished by any means, e.g., a folding device can be used to fold the pre-heat conductive sheet at a constant width. Formation of a laminate by rolling of the pre-heat conductive sheet can be accomplished by any means, e.g., by rolling the pre-heat conductive sheet around a shaft parallel to the longitudinal or lateral direction of the pre-heat conductive sheet.

From the perspective of preventing interlayer separation, it is preferred to heat the laminate at 120°C to 170°C for 2 to 8 hours while pressing the laminate in the lamination direction at a pressure of 0.1 MPa to 0.5 MPa.

In the laminate obtained by laminating, folding or rolling of the pre-heat conductive sheet(s), it is presumed that particulate carbon materials and fibrous carbon materials are aligned in a direction substantially perpendicular to the lamination direction.

[Slicing Step]

In the slicing step, the laminate obtained in the laminate forming step is sliced at an angle of 45° or less relative to the lamination direction to provide a heat conductive sheet formed of a sliced piece of the laminate. Any method can be used to slice the laminate, e.g., multi-blade method, laser processing method, water jet method, or knife processing method can be used, with the knife processing method being preferred because the thickness of the heat conductive sheet can be easily made uniform. Any cutting tool can be used to slice the laminate, e.g., a slicing member which has a smooth disk surface with a slit and a blade protruding from the slit (e.g., a plane or slicer equipped with a sharp blade) can be used.

The heat conductive sheet obtained from the slicing step generally has a configuration in which bar pieces containing the resin, particulate carbon material, fibrous carbon material and optional additive (sliced pieces of the pre-heat conductive sheet(s) of the laminate) are arranged side-by-side and bonded together.

From the perspective of increasing heat conductivity of the heat conductive sheet, the angle at which the laminate is sliced is preferably 30° or less relative to the lamination direction, more preferably 15° or less relative to the lamination direction, even more preferably substantially 0° relative to the lamination direction (i.e., along the lamination direction).

From the perspective of increasing the easiness of slicing, the temperature of the laminate at the time of slicing is preferably -20°C to 20°C, more preferably -10°C to 0°C. For the same reason, the laminate is preferably sliced while applying a pressure in a direction perpendicular to the lamination direction, more preferably while applying a pressure of 0.1 MPa to 0.5 MPa in a direction perpendicular to the lamination direction.

EXAMPLES

The following provides a more specific description of the present disclosure based on Examples, which however shall not be construed as limiting. In the following description, "%" and "parts" used to express quantities are by mass, unless otherwise specified.

In Examples and Comparative Examples, heat conductivity, Asker C hardness, tensile strength, tear strength, and powder fall resistance of heat conductive sheets were measured or evaluated using the methods described below.

<Heat Conductivity>

Heat conductive sheets were measured for thermal diffusivity $\alpha$ (m$^2$/s) in thickness direction, specific heat at constant pressure Cp (J/g·K), and specific gravity $\rho$ (g/m$^3$) using the methods described below.

[Thermal Diffusivity]

Thermal diffusivity was measured using a thermal analyzer (Thermowave Analyzer TA35, BETHEL Co., Ltd.).

[Specific Heat at Constant Pressure]

Using a differential scanning calorimeter (DSC8230, Rigaku), specific heat at a temperature of 25°C or 90°C was measured at a temperature increase rate of 10°C/min.

[Specific Gravity]

Specific gravity was measure using an automated densimeter (DENSIMETER-H, TOYO SEIKI Co., Ltd.).

Using the measured values, heat conductivity $\lambda$ (W/m·K) of the heat conductive sheet in the thickness direction at 25°C or 90°C was obtained based on the following Equation (I):

$$\lambda = \alpha \times Cp \times \rho \ldots (I)$$

<Asker C Hardness>

Asker C hardness was measured at 23°C using a hardness meter (ASKER CL-150LJ, KOBUNSHI KEIKI Co., Ltd.) in accordance with the Asker C method of the Society of Rubber Industry, Japan Standard (SRIS).

Specifically, a stack of 6 test pieces of heat conductive sheets sized to dimensions of 30 mm × 60 mm and 1.0 mm thickness was placed for at least 48 hours in a thermostatic chamber maintained at 23°C to prepare a sample for measurement of Asker C hardness. The damper height was adjusted such that the indicator points at from 95 to 98, and hardness 20 seconds after collision between the test piece and damper was measured 5 times. An average of measured hardness values was recorded as Asker C hardness of the sample.

<Tensile Strength and Tear Strength>

The heat conductive sheet was punched using dumbbell No.2 in accordance with JIS K6251 to prepare a test piece. Using a tensile tester (AG-IS20kN, SHIMADZU Corporation), the test piece was held at positions 1 cm from the opposite ends and pulled in a direction perpendicular to the normal to the surface of the sample at 25°C at a pulling rate of 500 mm/min to measure breaking strength (tensile strength).

The measurement of tear strength was made in the same manner as described above except that the heat conductive sheet was punched to prepare an unnicked angle test piece in accordance with JIS K6252 and the pulling rate was set to 200 mm/min.

<Powder Fall Resistance>

Kimwipes fully impregnated with cyclohexane was placed on the heat conductive sheet. A 2kg weight was put on the Kimwipes so that uniform pressure was applied. After 30 seconds, the weight was removed and the Kimwipes was visually observed for the presence of any substance attached to the Kimwipes, and evaluated according to the following criteria:

Good: No substance attached to Kimwipes
Poor: Substance attached to Kimwipes

(Preparation of Fibrous Carbon Nanostructures A including CNTs)

<Manufacture of Catalyst Substrate>

1.9 g of aluminum tri-sec-butoxide, an aluminum compound, was dissolved in 100 mL of 2-propanol as an organic solvent. Further, 0.9 g of triisopropanolamine as a stabilizer was added and dissolved to prepare coating liquid A for forming a catalyst support layer.

In addition, 174 mg of iron acetate, an iron compound, was dissolved in 100 mL of 2-propanol as an organic solvent. Further, 190 mg of triisopropanolamine as a stabilizer was added and dissolved to prepare coating liquid B for forming a catalyst layer.

Coating liquid A was applied by spin coating onto a surface of a base Fe-Cr alloy SUS 430 substrate (JFE Steel Corporation, 40 mm $\times$ 100 mm, 0.3 mm thickness, 18% Cr, arithmetic mean roughness Ra$\approx$0.59 $\mu$m) in an environment of room temperature of 25°C and 50% relative humidity. Specifically, 0.1 mL of coating liquid A was dropped onto the substrate and the substrate was rotated at 500 rpm for 10 seconds and then at 2,000 rpm for 20 seconds. Thereafter, coating liquid A was air-dried for 5 minutes, heated in an air environment at 300°C for 30 minutes, and then cooled to room temperature to form an alumina thin film (catalyst support layer) on the substrate.

Subsequently, in an environment of room temperature of 25°C and 50% relative humidity, coating liquid B was applied by spin coating onto the alumina thin film provided on the substrate. Specifically, 0.1 mL of coating liquid B was dropped on the substrate having the alumina thin film, and then the substrate was rotated at 500 rpm for 10 seconds and then at 2,000 rpm for 20 seconds. Thereafter, by air drying (drying temperature: 30°C) for 5 minutes, an iron thin film (catalyst layer) was formed. In this way, a catalyst substrate having, in order, an alumina thin film and an iron thin film on a substrate was obtained.

<Synthesis of Aggregate of Carbon Nanostructures>

The prepared catalyst substrate was placed in a reaction furnace (kept at a furnace temperature of 750°C, and a furnace pressure of $1.02 \times 10^5$ Pa) of a batch type manufacturing apparatus, and a mixed gas of $N_2$: 100 sccm and $H_2$: 800 sccm was introduced for 10 minutes. Subsequently, in the reactor kept at a furnace temperature of 750°C and a furnace pressure of $1.02 \times 10^5$ Pa, a mixed gas of $N_2$: 850 sccm, ethylene: 100 sccm and H2O-containing $N_2$ (23% relative humidity): 50 sccm was fed for 10 minutes.

Thereafter, $N_2$: 1,000 sccm was fed into the reaction furnace, and the remaining feedstock gas and catalyst activation substance were removed. In this way an aggregate of fibrous carbon nanostructures was obtained on the catalyst substrate. The fibrous carbon nanostructure aggregate thus produced was then separated from the catalyst substrate to afford fibrous carbon nanostructures A.

Evaluation and analysis of the resulting fibrous carbon nanostructures A confirmed that the yield was 1.9 mg/cm$^2$, G/D ratio was 3.4, density was 0.03 g/cm$^3$, BET specific surface area was 800 m$^2$/g, and carbon purity was 99.9%.

It was also confirmed that 100 fibrous carbon nanostructures A included 46 single- and two-walled carbon nanotubes and 54 single-walled GNTs.

Further, the t-plot of the fibrous carbon nanostructures was bent having a convex upward shape. S2/S1 was 0.24, and the bending point was at t = 0.6 nm.

(Preparation of Acrylic Resin)

100 parts of a monomer mixture composed of 94 parts of 2-ethylhexyl acrylate and 6 parts of acrylic acid, 0.03 parts of 2,2'-azobisisobutyronitrile and 700 parts of ethyl acetate were placed in a reactor and dissolved uniformly. After purging with nitrogen, a polymerization reaction was carried out at 80°C for 6 hours. The polymerization conversion rate was 97%. The resulting polymer was dried under reduced pressure to evaporate ethyl acetate to afford a viscous solid acrylic resin which had a weight-average molecular weight (Mw) of 270,000 and a molecular weight distribution (weight-average molecular weight (Mw)/number-average molecular weight (Mn)) of 3.1. The weight-average molecular weight (Mw) and the number-average molecular weight (Mn) were measured in terms of standard polystyrene by gel permeation chromatography using tetrahydrofuran as an eluent.

(Example 1)

1 part by mass of carbon nanostructures A as a fibrous carbon material, 200 parts by mass of expanded graphite (EC-50, Ito Graphite Industry Co., Ltd., average particle diameter: 250 $\mu$m) as a particulate carbon material, and 100 parts by mass of an acrylic resin as a resin were mixed under stirring for 1 hour in the presence of 20 parts of ethyl acetate as a solvent using a Hobart mixer (Model ACM-5 LVT, Kodaira Seisakusho Co., Ltd.). The resulting mixture was defoamed under vacuum for 1 hour, removing ethyl acetate simultaneously with defoaming to afford a composition containing carbon nanostructures A, expanded graphite, and acrylic resin. The resulting composition was charged into a disintegrator and disintegrated for 10 seconds.

Next, 5 g of the disintegrated composition was sandwiched between 50 $\mu$m-thick sandblasted PET films (protective films) and rolled under the following conditions: roll-to-roll gap = 330 $\mu$m, roll temperature = 50°C., roll linear pressure = 50 kg/cm, roll speed = 1 m/min to afford a pre-heat conductive sheet having a thickness of 0.3 mm.

200 pre-heat conductive sheets were prepared and stacked on top of each other to afford a laminate having a thickness of 6 cm.

The laminate of pre-heat conductive sheets was then cooled to -10°C with dry ice and sliced at an angle of 0° relative to the lamination direction (in other words, sliced in a direction normal to the main surface of the laminated pre-heat conductive sheets) using a slicer for woodworking (Super Surfacer SUPER MECA, Marunaka Tekkosho Inc.; the length of a blade protruding from the slit = 0.11 mm) while pressing a 6 cm $\times$ 30 cm cross section of the laminate at a pressure of 0.3 MPa to afford a heat conductive sheet with dimensions of 6 cm $\times$ 30 cm and 0.25 mm thickness.

The resulting heat conductive sheet contained expanded graphite having an average particle diameter of 5 $\mu$m and an aspect ratio of 3.0.

The resulting heat conductive sheet was then measured or evaluated for heat conductivity, Asker C hardness, tensile strength, tear strength and powder fall resistance. The results are given in Table 1.

(Examples 2-3)

Heat conductive sheets were manufactured as in Example 1 except carbon nanostructures A as a fibrous carbon material were used at amounts shown in Table 1, and evaluations were made as in Example 1. The results are given in Table 1.

(Example 4)

A heat conductive sheet was manufactured as in Example 1 except that 3 parts of multi-walled carbon nanotubes (NC 7000, Nanocyl Co., Ltd., BET specific surface area = 290 m$^2$/g; RBM spectrum = not observed; average diameter (Av) = 9.3 nm; standard deviation ($\sigma$) of diameters: 2.6 nm ($\sigma$); 3$\sigma$/Av ratio = 0.28; average length = 10 $\mu$m) was used as a fibrous carbon material instead of carbon nanostructures A, and evaluations were made as in Example 1. The results are given in Table 1.

(Comparative Example 1)

A heat conductive sheet was manufactured as in Example 1 except that no carbon nanostructures A were blended as a fibrous carbon material, and evaluations were made as in Example 1. The results are given in Table 1.

(Comparative Example 2)

Attempts were made to manufacture a heat conductive sheet as in Example 1 except that expanded graphite as a particulate carbon material was not blended, but to no avail because sheet form could not be retained.

Table 1

| | | Example 1 | Example 2 | Example 3 | Example 4 | Comparative Example 1 | Comparative Example 2 |
|---|---|---|---|---|---|---|---|
| Resin | Acrylic resin [parts by mass] | 100 | 100 | 100 | 100 | 100 | 100 |
| Particulate carbon material | Expanded graphite [parts by mass] | 200 | 200 | 200 | 200 | 200 | - |
| Fibrous carbon material | Carbon nanostructures A [parts by mass] | 1 | 3 | 5 | | | 1 |
| | Multi-walled CNTs [parts by mass] | - | - | - | 3 | - | |
| Evaluations | Heat conductivity [W/m·K] @25°C | 35 | 40 | 45 | 40 | 30 | |
| | Heat conductivity [W/m·K] @90°C | 36 | 42 | 48 | 41 | 32 | |
| | Asker C hardness [-] | 60 | 63 | 68 | 60 | 60 | |
| | Tensile strength [MPa] | 1.8 | 2.4 | 2.7 | 1.8 | 1.4 | |
| | Tear strength [N/mm] | 5.6 | 7.7 | 6.6 | 6.4 | 5.5 | |
| | Powder fall resistance [-] | Good | Good | Good | Good | Poor | |

As seen from Table 1, the heat conductive sheets prepared in Examples 1-4 which contain both of particulate and fibrous carbon materials would attain sufficiently high levels of heat conductivity, flexibility and strength at the same time as opposed to the heat conductive sheet prepared in Comparative Example 1 which contains only a particulate carbon material.

INDUSTRIAL APPLICABILITY

According to the present disclosure, it is possible to provide a heat conductive sheet that has sufficiently high levels of heat conductivity, flexibility and strength at the same time, and a method of effectively manufacturing the same.

**Claims**

1. A heat conductive sheet comprising: a resin; a particulate carbon material; and a fibrous carbon material in the form of fibrous carbon nanostructures including carbon nanotubes, **characterized in that** the fibrous carbon nanostructures including carbon nanotubes have an average diameter (Av) of 0.5 nm or more and 10 nm or less, and the fibrous carbon material is contained at an amount of 0.05% by mass to 5% by mass.

2. The heat conductive sheet of claim 1, wherein the heat conductive sheet is obtainable by slicing a laminate at an angle of 45° or less relative to a lamination direction, the laminate obtained either by laminating on top of each other pre-heat conductive sheets each obtained by shaping a composition containing the resin, the particulate carbon material, and the fibrous carbon material into a sheet by pressure application, or by folding or rolling a pre-heat conductive sheet obtained by shaping a composition containing the resin, the particulate carbon material, and the fibrous carbon material into a sheet by pressure application.

3. The heat conductive sheet of any one of claims 1 to 2, wherein the particulate carbon material is contained at an amount of 30% by mass to 90% by mass.

4. The heat conductive sheet of any one of claims 1 to 3, wherein the heat conductive sheet has a heat conductivity in thickness direction of 20 W/m·K or more.

5. The heat conductive sheet of any one of claims 1 to 4, wherein the heat conductive sheet has an Asker C hardness of 70 or less.

6. The heat conductive sheet of any one of claims 1 to 5, wherein the heat conductive sheet has a tensile strength of 1.5 MPa or more.

7. The heat conductive sheet of any one of claims 1 to 6, wherein the heat conductive sheet shows changes in heat conductivity of 20% or less between 25C° and 90C°.

8. The heat conductive sheet of any one of claims 1 to 7, wherein the heat conductive sheet has a tear strength of 5.6 N/mm or more.

9. A method of manufacturing a heat conductive sheet of claims 1 to 8, comprising:

shaping a composition containing the resin, the particulate carbon material, and the fibrous carbon material into a sheet by pressure application to provide a pre-heat conductive sheet;
obtaining a laminate either by laminating the pre-heat conductive sheets on top of each other or by folding or rolling the pre-heat conductive sheet; and
slicing the laminate at an angle of 45° or less relative to a lamination direction to provide the heat conductive sheet.


**Patentansprüche**

1. Wärmeleitende Schicht, umfassend: ein Harz; ein teilchenförmiges Kohlenstoffmaterial; und ein faseriges Kohlenstoffmaterial in Form von faserigen Kohlenstoffnanostrukturen, welche Kohlenstoffnanoröhren enthalten, **dadurch gekennzeichnet, dass**
die faserigen Kohlenstoffnanostrukturen, welche Kohlenstoffnanoröhren enthalten, einen durchschnittlichen Durchmesser (Av) von 0,5 nm oder mehr und 10 nm oder weniger haben, und das faserige Kohlenstoffmaterial in einer Menge von 0,05 Massenprozent bis 5 Massenprozent enthalten ist.

2. Wärmeleitende Schicht nach Anspruch 1, wobei die wärmeleitende Schicht durch Schneiden eines Laminats in einem Winkel von 45° oder weniger relativ zu einer Laminierungsrichtung erhältlich ist, wobei das Laminat entweder erhalten wird durch das Aufeinander-Laminieren von vor-wärmeleitenden Schichten, die jeweils erhalten werden durch Formen einer Zusammensetzung, die das Harz, das teilchenförmige Kohlenstoffmaterial und das faserige Kohlenstoffmaterial enthält, zu einer Schicht durch Druckanwendung, oder durch Falten oder Auswalzen einer vor-wärmeleitenden Schicht, die erhalten wird durch Formen einer Zusammensetzung, die das Harz, das teilchenförmige Kohlenstoffmaterial und das faserige Kohlenstoffmaterial enthält, zu einer Schicht durch Druckanwendung.

3. Wärmeleitende Schicht nach irgendeinem der Ansprüche 1 bis 2, wobei das teilchenförmige Kohlenstoffmaterial in einer Menge von 30 Massenprozent bis 90 Massenprozent enthalten ist.

4. Wärmeleitende Schicht nach irgendeinem der Ansprüche 1 bis 3, wobei die wärmeleitende Schicht eine Wärmeleitfähigkeit in Richtung der Dicke von 20 W/m·K oder mehr aufweist.

5. Wärmeleitende Schicht nach irgendeinem der Ansprüche 1 bis 4, wobei die wärmeleitende Schicht eine Asker-C-Härte von 70 oder weniger aufweist.

6. Wärmeleitende Schicht nach irgendeinem der Ansprüche 1 bis 5, wobei die wärmeleitende Schicht eine Zugfestigkeit von 1,5 MPa oder mehr aufweist.

**7.** Wärmeleitende Schicht nach irgendeinem der Ansprüche 1 bis 6, wobei die wärmeleitende Schicht Änderungen in der Wärmeleitfähigkeit von 20 % oder weniger zwischen 25 C° und 90 C° zeigt.

**8.** Wärmeleitende Schicht nach irgendeinem der Ansprüche 1 bis 7, wobei die wärmeleitende Schicht eine Reißfestigkeit von 5,6 N/mm oder mehr aufweist.

**9.** Verfahren zur Herstellung einer wärmeleitenden Schicht nach irgendeinem der Ansprüche 1 bis 8, umfassend:

Formen einer Zusammensetzung, die das Harz, das teilchenförmige Kohlenstoffmaterial und das faserige Kohlenstoffmaterial enthält, zu einer Schicht durch Druckanwendung, um eine vor-wärmeleitende Schicht bereitzustellen;
Erhalten eines Laminats entweder durch Aufeinander-Laminieren der vor-wärmeleitenden Schichten oder durch Falten oder Auswalzen der vor-wärmeleitenden Schicht; und
Schneiden des Laminats in einem Winkel von 45° oder weniger relativ zu einer Laminierungsrichtung, um die wärmeleitende Schicht bereitzustellen.

## Revendications

**1.** Feuille thermoconductrice comprenant : une résine ; un matériau carboné particulaire ; et un matériau carboné fibreux sous la forme de nanostructures carbonées fibreuses comportant des nanotubes de carbone, **caractérisée en ce que** les nanostructures carbonées fibreuses comportant des nanotubes de carbone ont un diamètre moyen (Av) de 0,5 nm ou plus et de 10 nm ou moins, et le matériau carboné fibreux est contenu en une quantité de 0,05 % en masse à 5 % en masse.

**2.** Feuille thermoconductrice selon la revendication 1, dans laquelle la feuille thermoconductrice peut être obtenue par tranchage d'un stratifié à un angle de 45° ou moins par rapport à une direction de stratification, le stratifié obtenu soit par stratification les unes au-dessus des autres de pré-feuilles thermoconductrices chacune obtenue par façonnage d'une composition contenant la résine, le matériau carboné particulaire, et le matériau carboné fibreux en une feuille par application de pression, soit par pliage ou laminage d'une pré-feuille thermoconductrice obtenue par façonnage d'une composition contenant la résine, le matériau carboné particulaire et le matériau carboné fibreux en une feuille par application de pression.

**3.** Feuille thermoconductrice selon l'une quelconque des revendications 1 à 2, dans laquelle le matériau carboné particulaire est contenu en une quantité de 30 % en masse à 90 % en masse.

**4.** Feuille thermoconductrice selon l'une quelconque des revendications 1 à 3, dans laquelle la feuille thermoconductrice a une conductivité thermique dans une direction d'épaisseur de 20 W/m·K ou plus.

**5.** Feuille thermoconductrice selon l'une quelconque des revendications 1 à 4, dans laquelle la feuille thermoconductrice a une dureté Asker C de 70 ou moins.

**6.** Feuille thermoconductrice selon l'une quelconque des revendications 1 à 5, dans laquelle la feuille thermoconductrice a une résistance à la traction de 1,5 MPa ou plus.

**7.** Feuille thermoconductrice selon l'une quelconque des revendications 1 à 6, dans laquelle la feuille thermoconductrice montre des changements de conductivité thermique de 20 % ou moins entre 25 °C et 90 °C.

**8.** Feuille thermoconductrice selon l'une quelconque des revendications 1 à 7, dans laquelle la feuille thermoconductrice a une résistance à la déchirure de 5,6 N/mm ou plus.

**9.** Procédé de fabrication d'une feuille thermoconductrice selon les revendications 1 à 8, comprenant :

le façonnage d'une composition contenant la résine, le matériau carboné particulaire et le matériau carboné fibreux en une feuille par application de pression pour fournir une pré-feuille thermoconductrice ;
l'obtention d'un stratifié soit par stratification des pré-feuilles thermoconductrices les unes au-dessus des autres soit par pliage ou laminage de la pré-feuille thermoconductrice ; et
le tranchage du stratifié à un angle de 45° ou moins par rapport à une direction de stratification pour fournir la feuille thermoconductrice.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010132856 A
- WO 2008062844 A
- EP 1471114 A1
- WO 2006011655 A